# EUROPÄISCHE PATENTSCHRIFT

(11) **EP 1 632 117 B1**
(45) Veröffentlichungstag und Bekanntmachung des Hinweises auf die Patenterteilung: **14.03.2007**
(21) Anmeldenummer: 04736642.2
(22) Anmeldetag: 11.06.2004
(51) Int. Cl.: H05K 7/14, H02M 7/00

(54) **ELEKTRONISCHE BAUGRUPPE ZUM SCHALTEN ELEKTRISCHER LEISTUNG**
ELECTRONIC COMPONENT FOR THE SWITCHING OF ELECTRICAL POWER
COMPOSANT ELECTRONIQUE POUR LA COMMUTATION D'UNE ALIMENTATION ELECTRIQUE

(30) Priorität: 11.06.2003 DE 10326321
(43) Veröffentlichungstag der Anmeldung: 08.03.2006
(73) Patentinhaber: Compact Dynamics GmbH, 82319 Starnberg (DE)
(72) Erfinder: GRÜNDL, Andreas, 81377 München (DE); HOFFMANN, Bernhard, 82319 Starnberg (DE)
(74) Vertreter: Schmidt, Steffen J.
(86) Internationale Anmeldenummer: PCT/EP2004/006322
(87) Internationale Veröffentlichungsnummer: WO 2004/110123

(56) Entgegenhaltungen:
- EP-A- 0 987 761
- US-A- 5 142 439
- US-A- 5 493 472
- US-A- 6 160 696
- US-B1- 6 249 448

## Beschreibung

### Hintergrund der Erfindung

Die Erfindung betrifft eine elektronische Baugruppe zum Schalten elektrischer Leistung. Derartige elektronischen Baugruppen können zum Beispiel als Halbbrückenschaltung ausgestaltet sein um zur Realisierung von Wechselrichtern oder Frequenzumrichtern für die unterschiedlichsten Anwendungsbereiche eingesetzt zu werden. Hierzu gehören das Betreiben von Synchron-, Asynchron-, Reluktanzmaschinen, permanenterregten Maschinen oder dergl. sowohl als Motoren als auch als Generatoren (siehe zum Beispiel die DE-A-40 27 969 oder die DE-A-42 30 510).

### Stand der Technik

Im Stand der Technik ist es bekannt elektrische Maschinen, insbesondere Wechselfeldmaschinen mit sog. Frequenzumrichtern zu betreiben. Üblicherweise enthalten diese Frequenzumrichter eine der Anzahl der Phasen der elektrischen Maschine entsprechende Anzahl von Halbbrückenanordnungen, die von einer Ansteuerelektronik mit Steuersignalen gespeist wird. Damit wird - je nach dem ob die elektrische Maschine als Motor oder als Generator betrieben wird - die elektrische Leistung der elektrischen Maschine entweder für die gewünschte Drehzahl und das gewünschte Drehmoment zugeführt oder der elektrischen Maschine die elektrische Leistung entnommen und für den nachgeschalteten Verbraucher in die gewünschte Betrags- und Phasenlage umgesetzt.

Insbesondere bei schnellschaltenden Frequenzumrichtern oder Wechselrichtern, treten dabei an den Schaltflanken der zu- bzw. abgeführten elektrischen Leistung hohe Über- oder Unterschwing-Impuls-Spannungsspitzen auf. Die Spannungsfestigkeit der in der elektronischen Baugruppe eingesetzten Halbleiterschalter aufgrund der auftretenden Überspannungs-Impulse muss erheblich höher sein als deren Betriebsspannungsfestigkeit. Dies erhöht die Kosten der Baugruppe nennenswert.

Die US 5,493,472 zeigt eine elektronische Baugruppe, in der eine Kondensatoranordnung mit zwei Bolzen auf Leistungsversorgungsschienen montiert wird. Die zwei Bolzen werden in zwei getrennte Bohrungen der Kondensatoranordnung eingeführt, um die Kondensatoranordnung mit den Leistungsversorgungsschienen zu verbinden. Die Kondensatoranordnung weist zwei Wicklungen auf, die durch die Leitungen miteinander und mit den Leitungsversorgungsschienen über die Bolzen verbunden sind.

In US 6,249,448 wird ein elektronisches Leistungsgerät beschrieben, bei dem die Kodensatoren in Gruppen zwischen den Leistungsschienen angeordnet sind. Die verwendeten Schalter sind parallel angeordnet.

### Der Erfindung zugrundeliegendes Problem

Der Erfindung liegt daher das Problem zugrunde, eine elektronische Baugruppe zum Schalten elektrischer Leistung bereitzustellen, die kostengünstig herstellbar ist, und kompakt baut, so dass sie auch für mobile Anwendungen (zum Beispiel im Automobilbereich) einsetzbar ist.

### Erfindungsctemäße Lösung

Die Erfindung sieht zur Lösung eine elektronische Baugruppe zum Schalten elektrischer Leistung vor, mit mindestens zwei Halbleiterschaltern, einem Leistungsausgang und zwei voneinander beabstandeten Leistungsversorgungsschienen, zwischen denen die mittels eines Steuereingang anzusteuernde Halbleiterschalter zum Bereitstellen der elektrischen Leistung an dem Leistungsausgang angeordnet sind. Eine die zwei Leistungsversorgungsschienen überbrückende Kondensatoranordnung erstreckt sich zumindest teilweise über die Länge der Leistungsversorgungsschienen. Zwei von jeweils einer der Leistungsversorgungsschienen ausgehende, die Kondensatoranordnung zumindest teilweise überdeckenden Kontaktlagen weisen freie Endbereiche auf, die sich gegenseitig zu der jeweils anderen der Leistungsversorgungsschienen hin überragen. Die beiden Kontaktlagen haben jeweils eine frei zugängliche Kontaktfläche, die zur Kontaktierung mit korrespondierend gestalteten Leistungsanschlüssen eingerichtet sind. Der Leistungsausgang weist eine Sammelschiene auf, die zwischen den beiden Leistungsversorgungsschienen angeordnet ist.

### Erfindungsgemäße Vorteile und Ausgestaltungen

Durch den erfindungsgemäßen Aufbau der elektronischen Baugruppe wird eine besonders kompakte Anordnung erreicht, die eine mit bisherigen Lösungen nicht vergleichbare Packungsdichte ermöglicht. Außerdem sind Spannungs-Impulsspitzen selbst beim Schalten mit Pulszeiten im Bereich von bis zu 10 - 1000 nsec und hohen Schaltleistungen im Bereich von mehreren 10 Watt bis zu mehreren Kilowatt erheblich minimiert. Dies führt zu einer erheblich erhöhten Störsicherheit. Die durch die erfindungsgemäße Anordnung ist in den elektrische Leistung führenden Leitungen zu/von den Halbleiterschalten den als Stützkondensator wirkenden Kondensatoranordnungen sehr niederinduktiv. und Ein weiterer wesentlicher Gesichtspunkt der Erfindung ist der modulare Aufbau, der eine problemlose Erweiterung und Anpassung der elektronischen Baugruppe an die jeweiligen Anforderungen erlaubt.

Da die Kondensatoranordnung einerseits räumlich und elektrisch sehr dicht bei den Kontaktflächen und andererseits auch räumlich und elektrisch sehr dicht bei den Halbleiterschaltern positioniert ist, gibt es keine Leitungsabschnitte, welche nennenswerte störende induktive Anteile hervorrufen. Damit sind sehr kurze Schaltzeiten realisierbar. Diese kurzen Schaltzeiten werden noch dadurch begünstigt, dass bei mehreren nebeneinander angeordneten erfindungsgemäßen Baugruppen die Kondensatoranordnungen und geringen Leitungsinduktivitäten einer Baugruppe dazu beitragen, etwaige Störimpulse benachbarter Baugruppen zu vermeiden.

Die Kontaktlagen können einen gemeinsamen Überdeckungsbereich haben, in dem sie von einander durch eine Isolierung getrennt sind. Vorzugsweise haben die beiden Kontaktlagen jeweils Kontaktflächen, die von einander im Wesentlichen in Richtung der Längserstreckung der Leistungsversorgungsschienen beabstandet sind. Außerdem können die zwei Leistungsversorgungsschienen im Wesentlichen parallel zueinander angeordnet sein.

Die zwischen den zwei Leistungsversorgungsschienen angeordneten Halbleiterschalter können an einem Substrat angeordnet sein, das vorzugsweise zur Kontaktierung einer Kühleinrichtung eingerichtet ist.

Der Leistungsausgang kann eine Sammelschiene aufweisen, die zwischen den beiden Leistungsversorgungsschienen angeordnet ist.

Bei einer bevorzugten Ausführungsform sind die Halbleiterschalter durch schnellschaltende, verlustarme Feldeffekt-Transistoren (FETs) oder durch schnellschaltende, verlustarme bipolare Transistoren mit isoliertem Gateanschluß (IGBTs) gebildet. Dabei können insbesondere MOS-FETs mit integrierten Freilaufdioden oder zu den Transistoren parallel geschaltete zusätzliche externe Freilaufdioden eingesetzt werden. Diese externen Freilaufdioden sind vorteilhaft in gleicher Weise wie die Halbleiterschalter und in unmittelbarer Nähe zu diesen bei einer der Leiterschienen angeordnet.

Die beiden Leistungsversorgungsschienen und die Sammelschiene können durch eine elektrisch isolierende Platine oder das Substrat mechanisch miteinander fest verbunden sein. Alternativ dazu können die Leistungsversorgungsschienen und die Sammelschiene durch elektrisch isolierende Stege, die zwischen den einzelnen Schienen angeordnet sind, mechanisch miteinander fest verbunden sein. Die Platine oder das Substrat kann auch zur Aufnahme von Leiterbahnen dienen, um den Halbleitern Steuersignale zuzuführen, um weitere aktive oder passive Baulelemente aufzunehmen, oder um Test- oder Mess-Stellen aus der Baugruppe herauszuführen. Die Platine bzw. das Substrat kann auch dazu dienen, Verbindungsleitungen zwischen den jeweiligen Steuereingängen der Halbleiterschalter und dem Anschluß zur Verbindung mit der Ansteuereinrichtung aufzunehmen.

Sofern die Anordnung eine Platine aufweist, kann diese mit Aussparungen versehen sein, die so bemessen sind, daß die auf den Leiterschienen oder dem Substrat direkt aufgebrachten Halbleiter (Transistoren und Dioden) zumindest mit ihren Kontaktierungsstellen freiliegen, also nicht durch die Platine verdeckt sind. Dies bewirkt, daß die effektive Bauhöhe der Halbleiter und der Platine sich nicht addieren. Vielmehr sind beide mit den Leiterschienen zumindest mit einigen ihrer Anschluss-Stellen direkt und auf gleichem Niveau verbunden. Die Platine dient damit sowohl der mechanischen Verbindung der Leiterschienen untereinander als auch der elektrischen Leitungsführung.

Die Verbindung der auf der Platine oder dem Substrat angeordneten Leiterbahnen oder den Leistungsversorgungsschienen bzw. der Sammelschiene mit den Kontaktierungsstellen der Halbleiter wird durch flächige, ggf. zum Höhenausgleich oder seitlichen Ausgleich abgewinkelte Kontaktbleche oder aus Blech gefertigten Kontaktbügeln hergestellt. Die Kontaktbleche oder -bügel sind an den Leiterbahnen bzw. den Leistungsversorgungsschienen oder der Sammelschiene einerseits und den Kontaktierungsstellen der Halbleiter andererseits angelötet oder angeschweißt. Dazu werden insbesondere bei den Halbleitern solche mit großflächigen Kontaktierungsstellen verwendet, welche eine Edelmetall-Auflage (vorzugsweise Gold oder Silber-Palladium, oder dergl.) haben.

Im Gegensatz zu anderen Verbindungstechniken, wie zum Beispiel Bonden, ist diese Vorgehensweise für die einzelnen Halbleiter weniger mechanisch beanspruchend und weniger fehleranfällig, so dass eine geringere Fehlproduktionsrate erreichbar ist. Ausserdem können die Kontaktbleche raumsparender und niederohmiger gestaltet werden. Insofern trägt diese Verbindungsfechnik in synergistischer Weise zu dem Gesamtkonzept bei, eine elektronische Baugruppe zum Schalen elektrischer Leistung kostengünstig herstellbar und kompakt bauend zu gestalten. Die so gestalteten Kontaktbleche verringern auch die störenden induktiven Beläge in den Verbindungen zwischen den Leiterbahnen bzw. den Leistungsversorgungsschienen oder der Sammelschiene einerseits und den Kontaktierungsstellen der Halbleiter andererseits. Gleichwohl kann diese Art der Verbindung in einer elektronischen Baugruppe auch unabhängig von der oben beschriebenen Konzept der Leistungszufuhr zu einer elektronischen Baugruppe eingesetzt werden. Auserdem kann hier durch einen einzigen Löt-Vorgang die Verbindung zwischen den beiden Enden der Kontaktbleche hergestellt werden, während beim Bonden die eine Vielzahl von einzelnen Bonddrähten an ihren beiden Enden mit der jeweiligen Kontaktstelle zusammengebracht werden müssen.

In einer bevorzugten Ausführungsform der Erfindung trägt die elektrisch isolierende Platine oder die Folie strombegrenzende Widerstände in den Ansteuerleitungen für die Halbleiterschalter, wobei diese (Gate-)Widerstände zwischen den jeweiligen Steuereingängen und dem Anschluß zur Verbindung mit der Ansteuereinrichtung vorgesehen sind.

Die elektronische Baugruppe kann wenigstens zwei Halbleiterschalter haben, die unter Bildung einer Halbbrücke in Serie geschaltet sind. Jeder der Halbleiterschalter hat einen Steuereingang zur Verbindung mit einer Ansteuereinrichtung. Der erste Halbleiterschalter ist mit seinem Source-Anschluß mit einem hohen Spannungspotential zu verbinden. Der zweite Halbleiterschalter ist mit seinem Drain-Anschluß mit einem niedrigen Spannungspotential zu verbinden.

Zur Bildung eines Ausgangs ist der Drain-Anschluß jedes ersten Halbleiterschalters mit dem Source-Anschluß des jeweiligen zweiten Halbleiterxhalters verbunden. Wenigstens eine Kondensatoranordnung ist zwischen dem hohen und dem niedrigen Spannungspotential angeordnet.

Jeweilige erste Halbleiterschalter sind mit ihrem Source-Anschluß mit einer gemeinsamen ersten, mit dem hohen Spannungspotential zu verbindenden metallischen Leiterschiene verbunden. Jeweilige zweite Halbleiterschalter sind mit ihrem Source-Anschluß mit einer gemeinsamen zweiten, den Ausgang bildenden metallischen Leiterschiene verbunden, wobei die zweite Leiterschiene im Abstand zur ersten Leiterschiene neben dieser angeordnet ist. Jeder zweite Halbleiterschalter ist mit seinem Drain-Anschluß mit einer gemeinsamen dritten, mit dem niedrigen Spannungspotential zu verbindenden metallischen Leiterschiene verbunden, die im Abstand zu und neben der ersten und der zweiten Leiterschiene angeordnet ist.

Die Kondensatoranordnung hat einen mit der ersten und der dritten Leiterschiene durch Anschlüsse verbundenen Stützkondensator, der den ersten und zweiten Halbleiterschalter derart übergreift, daß sich die Halbleiterschalter räumlich zwischen den entsprechenden Leiterschienen und dem Stützkondensator befinden. Der Steuereingang hat einen Anschluß zur Verbindung mit der Ansteuereinrichtung im Bereich einer ersten Stirnseite der Leiterschienen, und der Ausgang hat einen Anschluß zur Verbindung mit einem elektrischen Verbraucher im Bereich einer der ersten gegenüberliegenden, zweiten Stirnseite der zweiten Leiterschiene.

Die Erfindung betrifft auch eine Leistungsendstufe einer Ansteuereinrichtung für eine mehrphasige elektrische Maschine, bei der für jede Phase der elektrischen Maschine eine elektronische Baugruppe mit den obigen Merkmalen verwendet wird, wobei die elektronischen Baugruppen zumindest entlang eines Teils des Umfangs der elektrischen Maschine angeordnet sind.

Weitere Merkmale, Eigenschaften, Vorteile und mögliche Abwandlungen werden für einen Fachmann anhand der nachstehenden Beschreibung deutlich, in der auf die beigefügte Zeichnung Bezug genommen ist.

### Kurzbeschreibung der Zeichnung

In Fig. 1 ist ein schematischer Schaltplan einer elektronischen Baugruppe, die die Erfindung verkörpert, schematisch veranschaulicht.

In Fig. 2 ist eine schematische Querschnittsansicht einer erfindungsgemäßen elektronischen Baugruppe veranschaulicht.

In Fig. 2a ist eine teilweise schematische perspektivische Exposionsansicht aus Fig. 2 veranschaulicht.

In Fig. 3 ist eine schematische Draufsicht auf eine erfindungsgemäße elektronische Baugruppe gemäß Fig. 2 veranschaulicht.

In Fig. 4 ist eine schematische Draufsicht auf eine Zusammenschaltung mehrerer erfindungsgemäßer elektronischen Baugruppen gemäß Fig. 2 bzw. 3 veranschaulicht.

### Detaillierte Beschreibung der Zeichnung

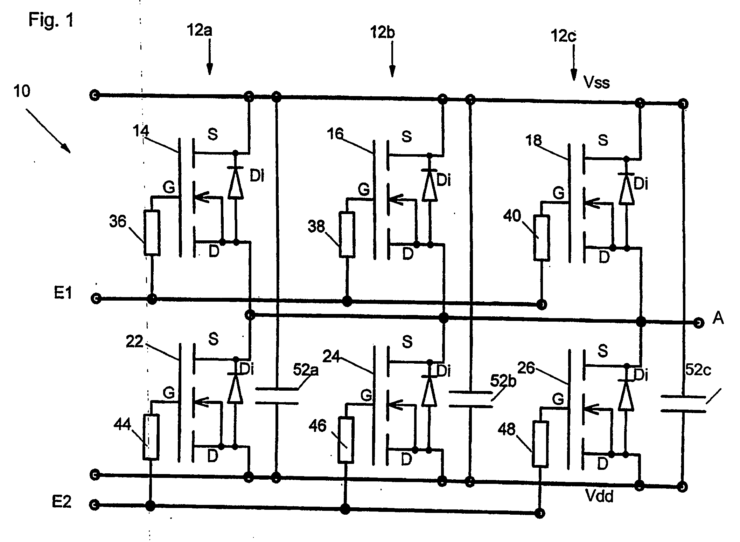

Bei der in der Fig 1 veranschaulichten erfindungsgemässen elektronischen Baugruppe handelt es sich um eine Halbbrückenschaltung 10, die drei parallel geschaltete Paare 12a, 12 b, 12c von N-Kanal MOSFETs aufweist, die jeder als Halbleiterschalter wirken. Jeweils zwei der MOSFETs 14, 22; 16, 24; 18, 26 die jeweils ein Paar bilden, sind in Serie geschaltet. Jeweils der erste MOSFET 14; 16; 18 jedes Paares liegt mit seinem Source-Anschluß S auf einem hohen Spannungspotential V_{SS}, und jeder zweite MOSFET 22; 24; 26 jedes Paares liegt mit seinem Drain-Anschluß D auf einem niedrigen Spannungspotential V_{DD}. Dabei sind zur Bildung eines Ausgangs A der Drain-Anschluß jedes der ersten MOSFETs 14; 16; 18 und der Source-Anschluß jedes der zweiten MOSFETs 22; 24; 26 miteinander verbunden.

Jeweils ein Steuereingang E1; E2 ist für die Gruppe der ersten MOSFETs 14; 16; 18 bzw. die Gruppe der zweiten MOSFETs 22; 24; 26 vorgesehen, wobei über Gatewiderstände 36; 38; 40 bzw. 44; 46; 48 die Gateanschlüsse G der jeweiligen MOSFETs angesteuert werden. Jeder der als MOSFETs ausgestalteten Halbleiterschalter hat zwischen seinen Leistungsanschlüssen D, S eine Freilaufdiode Di, die als sog. "Body-Diode" mit dem jeweiligen Halbleiterschalter integriert auf dem gleichen Halbleiterelement ausgeführt ist. Im übrigen wären separat vorgesehen Dioden direkt neben den MOSFETs ebenfalls an oder neben der ersten bzw. zweiten Leiterschiene angeordnet.

Zwischen dem hohen und dem niedrigen Spannungspotential V_{SS} und V_{DD} ist eine Stützkondensatoranordnung angeordnet, die durch einzelne parallelgeschaltete Stützkondensatoren 52a, 52b, 52c gebildet ist. Die Ausführung der Kondensatoranordnung 52a, 52b, 52c ist weiter unten detaillierter beschrieben. Die Ansteuerung der jeweiligen Gruppe der MOSFETs erfolgt mit einem (pulsweitenmodulierten) Steuersignal von bis zu mehr als 100 kHz Schaltfrequenz.

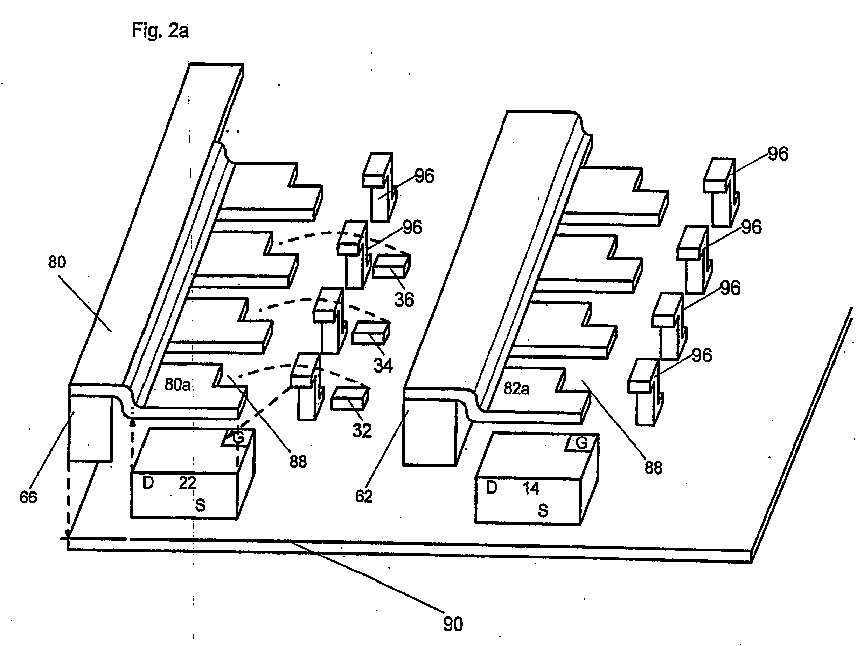

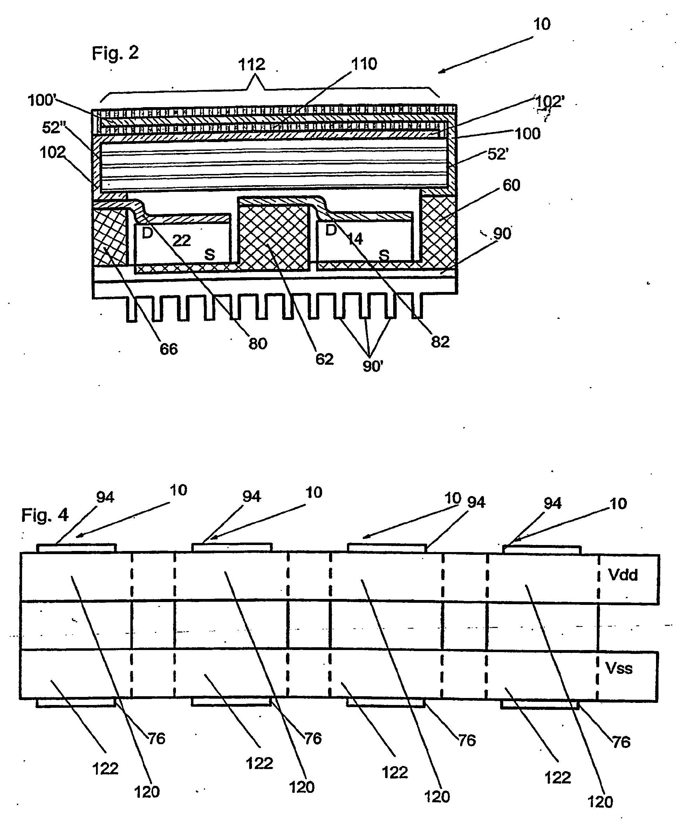

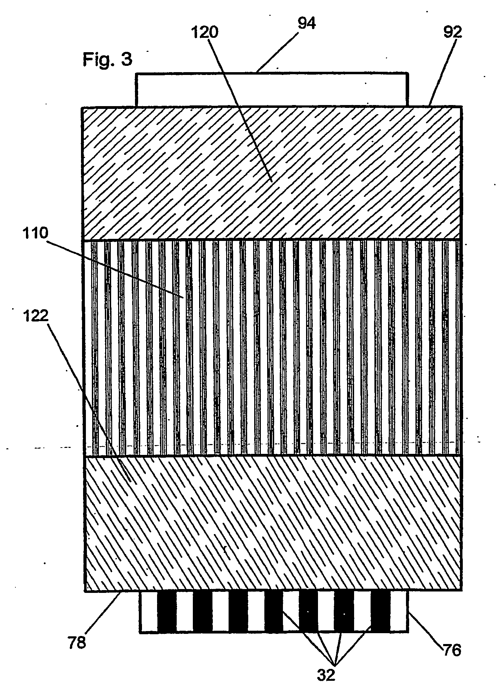

Wie in Fig. 2 gezeigt, sind die ersten MOSFETs 14; 16; 18 mit ihrem Source-Anschluß S mit einer gemeinsamen ersten, mit dem hohen Spannungspotential V_{SS} zu verbindenden metallischen Leiterschiene 60 elektrisch verbunden. Die Leiterschiene 60 hat ein im Querschnitt etwa L-förmiges Profil und ist aus Kupfer oder einem ähnlich gut elektrischen Strom und Wärme leitenden Material hergestellt. Der in Fig. 2 waagrechte Abschnitt der Leiterschiene 60 kann auch durch einen entsprechend geformten Kontaktfleck auf dem Substrat realisiert sein um die in diesem Fall rechteckige Leiterschiene 60 mit dem Source-Anschluß S des MOSFET 14 über eine Lötverbindung zu kontaktieren.

Die zweiten MOSFETs 22; 24; 26 sind mit Ihrem Source-Anschluß (S) mit einer gemeinsamen zweiten, den Ausgang A bildenden metallischen Leiterschiene 62 elektrisch verbunden, wobei die zweite Leiterschiene 62 im Abstand zur ersten Leiterschiene 60 neben dieser angeordnet ist. Auch die zweite Leiterschiene 62 hat ein im Querschnitt etwa rechteckiges oder L-förmiges Profil und ist aus dem gleichen Material wie die erste Leiterschiene 60 hergestellt.

Die zweiten MOSFETs 22; 24; 26 sind über einen oder mehrere Verbinderplatten oder Verbinderstege 80, die als Kontaktbleche dienen, jeweils mit ihren Drain-Anschlüssen D mit einer gemeinsamen dritten, mit dem niedrigen Spannungspotential V_{DD} zu verbindenden metallischen Leiterschiene 66 verbunden, wobei die dritte Leiterschiene 66 im Abstand zu und neben der zweiten Leiterschiene 62 angeordnet ist.

In ähnlicher Weise wie die zweiten MOSFETs sind die ersten MOSFETs 14; 16; 18 über einen oder mehrere als Kontaktbleche dienende Verbinderplatten oder Verbinderstege 82 jeweils mit ihren Drain-Anschlüssen D mit der zweiten Leiterschiene 62 verbunden.

Die Kondensatoranordnung 52 ist mit der ersten und der dritten Leiterschiene 60, verlötete oder verschweißte blockförmige Folienkondensatoren 52 a .. 52c gebildet. Die Follenkdndensatoren 52a .. 52c sind entlang der Leiterschienen nebeneinander angeordnet. Die Folienkondensatoren übergreifen die jeweiligen ersten und zweiten Halbleiterschalter derart, daß sich die Halbleiterschalter räumlich zwischen den entsprechenden Leiterschienen und dem jeweiligen Folienkondensator befinden.

In Fig. 2a sind die mit den Leiterschienen 62, 66 verlöteten oder verschweissten Verbinderplatten 80, 82 gezeigt. Um den Höhenunterschied zwischen der Oberseite den Leiterschienen und den Halbleiterschaltern auszugleichen, sind die Verbinderplatten 80, 82 abgekröpft. Für jeden der Halbleiterschalter 14..., 22 ... sind Kontaktfahnen 80a, 82a vorgesehen, die jeweils an ihrem freien Ende eine seitliche Ausnehmung 88 haben. In diese Ausnehmungen 88 reicht eine Z-förmig gebogene Verbindung 96 zum Gate-Anschluss G der Halbleiterschalter 14..., 22 ..... Die Verbindung 96 stellt eine Leitung zu den ebenfalls auf der Platine 90 angeordneten Gate-Widerständen 36; 38; 40 bzw. 44; 46; 48 (siehe Fig. 1 bzw. Fig. 2a), die als SMD-Bauteile (surface mounted device) ausgeführt sind, her. Auch diese Leitung zwischen den Gate-Widerständen und den Steuereingängen G der MOSFETs ist durch Verlöten oder Verschweissen der Verbindungen 96 mit den Steuereingängen G der MOSFETs bzw. der Platine 90 realisert.

Da Fig. 2a eine teilweise Explosionsdarstellung ist, zeigen die gestrichelten Pfeile die Position der einzelnen Komponenten in ihrer Zusammenstellung. Dabei sind der Übersichtlichkeit wegen nicht alle Komponenten der elektronischen Baugruppe gezeigt. Insbesondere ist auch nicht das Layout der Leiterbahnen auf dem Substrat 90 im Detail veranschaulicht.

Die zwischen den zwei Leistungsversorgungsschienen angeordneten Halbleiterschalter sind an einem Substrat 90 angeordnet, das mit Kühlrippen 90' zur Kontaktierung einer Kühleinrichtung, zum Beispiel einer Fluidkühlung versehen ist.

An den beiden äußeren Leiterschienen 60, 66 welche als Leistungsversorgungsschienen dienen, sind an deren Oberseite (siehe Fig. 2) aus Kupferblech oder einem ähnlich gut leitenden Material hergestellte Kontaktlagen 100, 102 angelötet oder angeschweißt. Diese Kontaktlagen 100, 102 übergreifen die jeweiligen Seitenflächen 52' und 52 " der Kondensatoranordnung 52 a .. 52c. Jede der Kontaktlagen 100, 102 haben freie Endbereiche 100', 102 ', die sich gegenseitig zu der jeweils anderen der Leistungsversorgungsschienen hin überragen. (siehe Fig.2). Die beiden Kontaktlagen 100, 102 haben einen gemeinsamen Überdeckungsbereich 110 haben, in dem sie von einander durch eine Isolierungsschicht 112 getrennt sind.

Wie in Fig. 3 veranschaulicht, haben die beiden Kontaktlagen 100, 102 jeweils im Bereich der Enden der elektronische Baugruppe eine (von oben) frei zugängliche im Wesentlichen rechteckige Kontaktfläche 120, 122, die zur Kontaktierung mit korrespondierend gestalteten Leistungsanschlüssen eingerichtet sind und in Richtung der Längserstreckung der Leistungsversorgungsschienen beabstandet sind. Um die näher bei der Oberfläche der Kondensatoranordnung 52 a 52c liegende Kontaktlage 102 für den entsprechenden Leistungsanschluss zugänglich zu machen, sind die Isolierungsschicht 112 und die darüber liegende Kontaktlage 100 entsprechend verkürzt.

Der von aussen (oben) zugängliche Bereich zwischen den beiden Kontaktflächen 120, 122 ist durch die zurück gefaltete Isollerungsschicht 112 abgedeckt (siehe Fig. 2 bzw.3).

Um eine separat herstellbare und handhabbare Einheit einer Halbbrückenbaugruppe bereitzustellen, sind die erste, zweite und dritte Leiterschiene 60, 62, 66 durch eine elektrisch isolierende Platine 90 mechanisch miteinander fest verbunden. Dazu ist die Platine 90 mit den Leiterschienen fest verbunden.

Wie in Fig. 3 gezeigt, sind die jeweiligen Steuereingänge E1, E2 zu Verbindungsleitungen zwischen den jeweiligen Steuereingängen G der Halbleiterschalter sowie einige Testpins an einer Anschlußleiste 76 an der Platine 90 zur Verbindung mit einer Ansteuereinrichtung im Bereich einer ersten Stirnseite 78 (in Fig. 3 unten) der Leiterschienen 60, 62, 66 herausgeführt, während der Ausgang A an einen Anschluß 94 zur Verbindung mit einem elektrischen Verbraucher im Bereich einer der ersten Stirnseite 78 gegenüberliegenden, zweiten Stirnseite 92 der zweiten Leiterschiene 62 (in Fig. 3 oben) herausgeführt ist.

Fig. 4 zeigt eine Draufsicht auf eine Zusammenschaltung mehrerer erfindungsgemäßer elektronischen Baugruppen 10 gemäß Fig. 2 bzw. 3. Solchermassen zusammengeschaltete elektronische Baugruppen 10, die über Stromzuführungen Vss und Vdd mit elektrischer Leistung versorgt werden, können entlang des Umfangs einer mehrphasigen elektrischen Maschine verteilt angeordnet sein, wobei für jede Phase der elektrischen Maschine eine elektronische Baugruppe 10 verwendet wird.

## Patentansprüche

1. Eine elektronische Baugruppe zum Schalten elektrischer Leistung, mit
- mindestens zwei Halbleiterschaltern (14,22; 16,24; 18,26),
- einem Leistungsausgang (62),
- zwei voneinander beabstandeten Leistungsversorgungsschienen (60, 66), zwischen denen die mittels eines Steuereingangs (G) anzusteuernde Halbleiterschalter zum Bereitstellen der elektrischen Leistung an dem Leistungsausgang (62) angeordnet sind,
- einer die zwei Leistungsversorgungsschienen überbrückenden Kondensatoranordnung (52a, 52b, 52c), die sich zumindest teilweise über die Länge der Leistungsversorgungsschienen erstreckt, **gekennzeichnet durch**
- zwei von jeweils einer der Leistungsversorgungsschienen ausgehenden, die Kondensatoranordnung zumindest teilweise überdeckenden Kontaktlagen (100,102), wobei die Kontaktlagen freie Endbereiche (100', 102') aufweisen, die sich gegenseitig zu der jeweils anderen der Leistungsversorgungsschienen hin überragen, wobei
- die beiden Kontaktlagen jeweils eine frei zugängliche Kontaktfläche (120, 122) haben, die zur Kontaktierung mit korrespondierend gestalteten Leistungsanschlüssen eingerichtet sind, und
- der Leistungsausgang (62) eine Sammelschiene aufweist, die zwischen den beiden Leistungsversorgungsschienen angeordnet ist.

2. Die elektronische Baugruppe nach Anspruch 1, wobei die Kontaktlagen einen gemeinsamen Überdeckungsbereich haben, in dem sie voneinander durch eine Isolierung getrennt sind.

3. Die elektronische Baugruppe nach Anspruch 1 oder 2, wobei die beiden Kontaktlagen jeweils Kontaktflächen haben, die voneinander im Wesentlichen in Richtung der Längserstreckung der Leistungsversorgungsschienen beabstandet sind.

4. Die elektronische Baugruppe nach einem der Ansprüche 1 bis 3, wobei die zwei Leistungsversorgungsschienen im Wesentlichen parallel zueinander angeordnet sind.

5. Die elektronische Baugruppe nach einem der Ansprüche 1 bis 4, wobei die zwischen den zwei Leistungsversorgungsschienen angeordneten Halbleiterschalter an einem Substrat angeordnet sind, das vorzugsweise zur Kontaktierung einer Kühleinrichtung eingerichtet ist.

6. Die elektronische Baugruppe nach einem der Ansprüche 1 bis 5, wobei
- die Halbleiterschalter durch schnellschaltende, verlustarme Feldeffekt-Transistoren (FETs) oder durch schnellschaltende, verlustarme bipolare Transistoren mit isoliertem Gateanschluß (IGBTs) gebildet sind, wobei insbesondere MOS-FETs mit integrierten Freilaufdioden oder zu den Transistoren parallel geschaltete zusätzliche externe Freilaufdioden eingesetzt sind.

7. Die elektronische Baugruppe nach einem der Ansprüche 1 bis 6, wobei
- zwischen auf der Platine oder dem Substrat angeordneten Leiterbahnen oder den Leistungsversorgungsschienen bzw. der Sammelschiene einerseits und Kontaktierungsstellen der Halbleiter andererseits flächige, zum Höhenausgleich oder seitlichen Ausgleich abgewinkelte Kontaktbleche als elektrische Verbindung angelötet oder angeschweißt sind.

8. Die elektronische Baugruppe nach Anspruch 7, wobei
- die Halbleiter großflächige Kontaktierungsstellen mit einer Edelmetall-Auflage haben.

9. Die elektronische Baugruppe nach einem der Ansprüche 1 bis 8, wobei
- wenigstens zwei Halbleiterschalter (14, 22; 24, 18, 26;) unter Bildung einer Halbbrücke (12a, 12b, 12c) in Serie geschaltet sind;
- jeder Halbleiterschalter (14, 22; 24, 18, 26) einen Steuereingang (G) zur Verbindung mit einer Ansteuereinrichtung aufweist;
- der erste Halbleiterschalter (14, 16, 18) mit seinem Source-Anschluß (S) mit einem hohen Spannungspotential (V_{SS}) zu verbinden ist;
- der zweite Halbleiterschalter (22, 24, 26) mit seinem Drain-Anschluß (D) mit einem niedrigen Spannungspotential (V_{DD}) zu verbinden ist;
- zur Bildung eines Ausgangs (A) der Drain-Anschluß (D) jedes ersten Halbleiterschalters (14, 16, 18) mit dem Source-Anschluß (S) des jeweiligen zweiten Halbleiterschalters (22, 24, 26) verbunden ist; und
- wenigstens eine Kondensatoranordnung (52) zwischen dem hohen und dem niedrigen Spannungspotential (V_{SS}, V_{DD}) angeordnet ist;
- jeweilige erste Halbleiterschalter (14, 16, 18) mit ihrem Source-Anschluß (S) auf einer gemeinsamen ersten, mit dem hohen Spannungspotential (V_{SS}) zu verbindenden metallischen Leiterschiene (60) angeordnet sind;
- jeweilige zweite Halbleiterschalter (22, 24, 26) mit ihrem Source-Anschluß (S) auf einer gemeinsamen zweiten, den Ausgang (A) bildenden metallischen Leiterschiene (62) angeordnet sind, wobei die zweite Leiterschiene (62) im Abstand zur ersten Leiterschiene (60) neben dieser angeordnet ist;
- jeder zweite Halbleiterschalter (22, 24, 26) mit seinem Drain-Anschluß (D) miteiner gemeinsamen dritten, mit dem niedrigen Spannungspotential (V_{DD}) zu verbindenden metallischen Leiterschiene (66) verbunden ist, die im Abstand zu und neben der ersten und der zweiten Leiterschiene (60, 62) angeordnet ist;
- die Kondensatoranordnung (52) einen mit der ersten und der dritten Leiterschiene (60, 66) durch Anschlüsse verbundenen Stützkondensator (52a .. 52d) aufweist, der den ersten und zweiten Halbleiterschalter (14, 22; 24, 18, 26; 20, 28) derart übergreift, daß sich die Halbleiterschalter räumlich zwischen den entsprechenden Leiterschienen (60, 66) und dem Stützkondensator (52a .. 52d) befinden;
- der Steuereingang (G) einen Anschluß (76) zur Verbindung mit der Ansteuereinrichtung im Bereich einer ersten Stirnseite (78) der Leiterschienen (60, 62, 68) aufweist, und
- der Ausgang (A) einen Anschluß zur Verbindung mit einem elektrischen Verbraucher im Bereich einer der ersten gegenüberliegenden, zweiten Stirnseite (82) der zweiten Leiterschiene (62) aufweist.

10. Die elektronische Baugruppe nach einem der Ansprüche 1 bis 9, wobei
- die drei Schienen (60, 62, 66) durch eine elektrisch isolierende Platine (90) mechanisch miteinander fest verbunden sind.

11. Die elektronische Baugruppe nach einem der Ansprüche 1 bis 10, wobei
- die drei Schienen (60, 62, 66) durch elektrisch isolierende Stege, die zwischen den einzelnen Leiterschienen angeordnet sind, mechanisch miteinander fest verbunden sind.

12. Leistungsendstufe einer Ansteuereinrichtung für eine mehrphasige elektrischen Maschine, **dadurch gekennzeichnet, daß** für jede Phase der elektrischen Maschine wenigstens eine elektronische Baugruppe nach einem der vorhergehenden Ansprüche bereitgestellt ist, wobei die elektronische Baugruppe zumindest entlang eines Teils des Umfangs der elektrischen Maschine angeordnet sind.

## Claims

1. An electronic assembly for switching electric power, comprising
- at least two semiconductor switches (14, 22; 16,24; 18, 26);
- a power output (62);
- two spaced power supply buses (60, 66) between which the semiconductor switches to be driven by means of a control input (G) are arranged at the power output (62), for providing the electric power,
- a capacitor arrangement (52a, 52b, 52c) which bridges the two power supply buses and extends at least partially over the length of the power supply buses, **characterized by**
- two contact layers (100, 102) originating from one each of the power supply buses and covering the capacitor arrangement at least partially, wherein the contact layers comprise free end portions (100', 102') which mutually project one another towards the respective other one of the power supply buses,
- the two contact layers have a freely accessible contact area (120, 122) each which are adapted for contact making with correspondingly configured power terminals, and
- the power output (62) comprises a busbar arranged between the two power supply buses.

2. The electronic assembly according to Claim 1, wherein the contact layers have a common covering zone in which they are separated from one another by an insulation.

3. The electronic assembly according to Claim 1 or 2, wherein the two contact layers have contact areas each which are spaced from one another essentially in the direction of the longitudinal extension of the power supply buses.

4. The electronic assembly according to one of Claims 1 to 3, wherein the two power supply buses are arranged essentially parallel to one another.

5. The electronic assembly according to one of Claims 1 to 4, wherein the semiconductor switches arranged between the two power supply buses are arranged on a substrate which is preferably adapted for contact making with a cooling device.

6. The electronic assembly according to one of Claims 1 to 5, wherein
- the semiconductor switches are formed by high-speed switching low-loss field effect transistors (FETs) or by high-speed switching low-loss bipolar transistors with insulated gate terminals (IGBTs) wherein, in particular, MOSFETs with integrated free-wheeling diodes or with additional external free-wheeling diodes which are connected in parallel with the transistors are employed.

7. The electronic assembly according to one of Claims 1 to 6, wherein
- plane contact sheets which are angled for a height compensation or a lateral compensation are soldered or welded as electrical connection between the printed conductors arranged on the circuit board or the substrate, or the power supply buses or the busbar, respectively, on the one hand, and contact making points of the semiconductors, on the other hand.

8. The electronic assembly according to Claim 7, wherein
- the semiconductors have large-surface contact making points with a coating of noble metal.

9. The electronic assembly according to one of Claims 1 to 8, wherein
- at least two semiconductor switches (14, 22; 24, 18, 26) forming a half-bridge (12a, 12c, 12c) are connected in series;
- each semiconductor switch (14, 22; 24, 18, 26) has a control input (G) for connection with a driving means;
- the first semiconductor switch (14, 16, 18) has to be connected with its source terminal (S) to a high voltage potential (V_{SS});
- the second semiconductor switch (22, 24, 26) has to be connected with its drain terminal (D) to a low voltage potential (V_{DD});
- for forming an output (A), the drain terminal (D) of each first semiconductor switch (14, 16, 18) is connected with the source terminal (S) of the respective second semiconductor switch (22, 24, 26); and
- at least one capacitor arrangement (52) is arranged between the high and the low voltage potential (Vss, V_{DD});
- respective first semiconductor switches (14, 16, 18) are arranged with their source terminal (S) on a common first metallic conductor rail (60) to be connected with the high voltage potential (Vss);
- respective second semiconductor switches (22, 24, 26) are arranged with their source terminal (S) on a common second metallic conductor rail (62) forming the output (A), the second conductor rail (62) being arranged spaced from and adjacent to the first conductor rail (60);
- each second semiconductor switch (22, 24, 26) is connected with its drain terminal (D) to a common third metallic conductor rail (66) to be connected with the low voltage potential (V_{DD}) being arranged spaced from and adjacent to the first and second conductor rails (60, 62);
- the capacitor arrangement (52) comprises a back-up capacitor (52a, ..., 52d) connected to the first and the third conductor rail (60, 66) via terminals, which encompasses the first and the second semiconductor switches (14, 22; 24, 18, 26; 20, 28) in such a manner that the semiconductor switches are located spatially between the corresponding conductor rails (60, 66) and the back-up capacitor (52a, ..., 52d);
- the control input (G) comprises a terminal (76) for connection with the driving means in the area of a first face (78) of the conductor rails (60, 62, 68), and
- the output (A) comprises a terminal for connection with an electric load in the area of a second face (82) of the second conductor rail (62) that is located opposite the first face.

10. The electronic assembly according to one of Claims 1 to 9, wherein
- the three rails (60, 62, 66) are mechanically firmly connected with each other by an electrically insulating circuit board (90).

11. The electronic assembly according to one of Claims 1 to 10, wherein
- the three rails (60, 62, 66) are mechanically firmly connected with each other by electrically insulating lands arranged between the individual conductor rails.

12. A power output stage of a driving means for a multiphase electrical machine, **characterised in that** at least one electronic assembly according to one of the previous claims is provided for each phase of the electrical machine, the electronic assembly being arranged at least along a portion of the circumference of the electrical machine.

## Revendications

1. Composant électronique pour commuter une puissance électrique, comprenant :
- au moins deux commutateurs à semi-conducteurs (14, 22 ; 16, 24 ; 18, 26),
- une sortie de puissance (62),
- deux rails d'alimentation de puissance (60, 66) à distance l'un de l'autre, entre lesquels sont agencés les commutateurs à semi-conducteurs, destinés à être pilotés au moyen d'une entrée de commande (G), pour mettre à disposition la puissance électrique à la sortie de puissance (62),
- un agencement à condensateurs (52a, 52b, 52c) en pont entre les deux rails d'alimentation de puissance, qui s'étend au moins partiellement sur la longueur des rails d'alimentation de puissance,
**caractérisé par**
- deux couches de contact (100, 102) qui partent respectivement de l'un des rails d'alimentation de puissance et qui couvrent au moins partiellement l'agencement à condensateurs, lesdites couches de contact présentant des zones terminales libres (100', 102') qui se dépassent mutuellement en direction de l'autre rail d'alimentation de puissance respectif, de sorte que
-- les deux couches de contact possèdent une surface de contact (120, 122) librement accessible, qui sont agencées pour venir en contact avec des raccords de puissance de conception correspondante, et
-- la sortie de puissance (62) comprend un rail collecteur qui est agencé entre les deux rails d'alimentation de puissance.

2. Composant électronique selon la revendication 1, dans lequel les couches de contact comprennent une région de recouvrement commune dans laquelle elles sont séparées l'une de l'autre par une isolation.

3. Composant électronique selon la revendication 1 ou 2, dans lequel les deux couches de contact possèdent des surfaces de contact respectives, qui sont écartées l'une de l'autre essentiellement en direction de l'extension longitudinale des rails d'alimentation de puissance.

4. Composant électronique selon l'une des revendications 1 à 3, dans lequel les deux rails d'alimentation de puissance sont agencés essentiellement parallèlement l'un à l'autre.

5. Composant électronique selon l'une des revendications un 1 à 4, dans lequel les commutateurs à semi-conducteurs agencés entre les deux rails d'alimentation de puissance sont agencés sur un substrat qui est de préférence agencé pour venir en contact avec un moyen de refroidissement.

6. Composant électronique selon l'une des revendications 1 à 5, dans lequel les commutateurs à semi-conducteurs sont formés par des transistors à effet de champ (FET) à commutation rapide et à faibles pertes, ou par des transistors bipolaires à grille isolée (IGBT) à commutation rapide et à faibles pertes, et dans lequel on emploie en particulier des transistors à effet de champ en technologie MOS avec diodes de roue libre intégrées ou des diodes de roue libre externes additionnelles branchées parallèlement aux transistors.

7. Composant électronique selon l'une des revendications 1 à 6, dans lequel des tôles de contact étendues rabattues pour la compensation en hauteur ou pour la compensation latérale sont soudées ou brasées à titre de jonction électrique entre les pistes conductrices agencées sur la platine ou sur le substrat ou les rails d'alimentation de puissance ou encore le rail collecteur d'une part et les emplacements de contact des semi-conducteurs d'autre part.

8. Composant électronique selon la revendication 7, dans lequel les semi-conducteurs possèdent des emplacements de contact à grande surface avec un appui en métal noble.

9. Composant électronique selon l'une des revendications 1 à 8, dans lequel :
-- au moins deux commutateurs à semi-conducteurs (14, 22 ; 24, 18, 26) sont branchés en série en formant un demi-pont (12a, 12b, 12c) ;
-- chaque commutateur à semi-conducteurs (14, 22 ; 24, 18, 26) comprend une entrée de commande (G) pour la liaison avec un moyen de pilotage ;
-- le premier commutateur à semi-conducteurs (14, 16, 18) est destiné à être relié par sa source (S) à un potentiel électrique élevé (V_{SS}) ;
-- le second commutateur à semi-conducteurs (22, 24, 26) est destiné à être relié par son drain (D) à un potentiel électrique faible (V_{DD}) ;
-- pour réaliser une sortie (A), le drain (D) de chaque premier commutateur à semi-conducteurs (14, 16, 18) est relié à la source (S) du second commutateur à semi-conducteurs correspondant (22, 24, 26) ; et
-- au moins un agencement à condensateurs (52) est agencé entre le potentiel électrique élevé et le potentiel électrique faible (V_{SS}, V_{DD}) ;
-- des premiers commutateurs à semi-conducteurs respectifs (14, 16, 18) sont reliés par leurs sources (S) à un premier rail conducteur métallique commun (60) destiné à être relié au potentiel électrique élevé (V_{SS}) ;
-- des seconds commutateurs à semi-conducteurs respectifs (22, 24, 26) sont reliés par leurs sources (S) à un second rail conducteur métallique commun (62) formant la sortie (A), ledit second rail conducteur (62) étant agencé à distance du premier rail conducteur (60) à côté de celui-ci ;
-- chaque second commutateur à semi-conducteurs (22, 24, 26) est relié par son drain (D) à un troisième rail conducteur métallique commun (66) destiné à être raccordé au potentiel électrique faible (V_{DD}), et qui est agencé à distance et à côté du premier et du second rail conducteur (60, 62) ;
-- l'agencement à condensateurs (52) comprend un condensateur de couplage (52a ... 52d) connecté au premier et au troisième rail conducteur (60, 66) et coiffant le premier et le second commutateur à semi-conducteurs (14, 22 ; 24, 18, 26 ; 20, 28) de telle manière que les commutateurs à semi-conducteurs se trouvent dans l'espace entre les rails conducteurs (60, 66) correspondants et le condensateur de couplage (52a ... 52d) ;
-- l'entrée de commande (G) comprend une borne (76) pour la liaison avec le moyen de pilotage dans la région d'un premier côté frontal (78) des rails conducteurs (60, 62, 68), et
-- la sortie (A) comprend un raccordement pour la liaison avec un dispositif utilisateur électrique dans la région d'un second côté frontal (82), à l'opposé du premier, du second rail conducteur (62).

10. Composant électronique selon l'une des revendications 1 à 9, dans lequel les trois rails (60, 62, 66) sont reliés solidairement les uns aux autres sur le plan mécanique par une platine (90) électriquement isolante.

11. Composant électronique selon l'une des revendications 1 à 10, dans lequel les trois rails (60, 62, 66) sont reliés solidairement les uns aux autres sur le plan mécanique par des barrettes électriquement isolantes, qui sont agencées entre les rails conducteurs individuels.

12. Étage final de puissance d'un moyen de pilotage pour un groupe électrique à plusieurs phases, **caractérisé en ce que**, pour chaque phase du groupe électrique, on prévoit au moins un composant électronique selon l'une des revendications précédentes, ledit composant électronique étant agencé au moins le long d'une partie de la périphérie du groupe électrique.
